# EUROPÄISCHE PATENTSCHRIFT

(11) **EP 2 240 728 B1**
(45) Veröffentlichungstag und Bekanntmachung des Hinweises auf die Patenterteilung: **20.06.2012**
(21) Anmeldenummer: 08860405.3
(22) Anmeldetag: 08.12.2008
(51) Int. Cl.: F24J 2/04, F24J 2/52, H01L 31/05, H01L 31/058

(54) **PHOTOVOLTAIK-MODULEINRICHTUNG**
PHOTOVOLTAIC MODULAR DEVICE
DISPOSITIF MODULAIRE PHOTOVOLTAIQUE

(30) Priorität: 10.12.2007 DE 102007059650
(43) Veröffentlichungstag der Anmeldung: 20.10.2010
(73) Patentinhaber: Habel, Thomas, 97996 Niederstetten (DE)
(72) Erfinder: Habel, Thomas, 97996 Niederstetten (DE)
(74) Vertreter: Clemens, Gerhard
(86) Internationale Anmeldenummer: PCT/DE2008/002019
(87) Internationale Veröffentlichungsnummer: WO 2009/074135

(56) Entgegenhaltungen:
- WO-A1-01/75377
- WO-A1-94/16170
- DE-A1- 4 140 682
- JP-A- 2000 027 395
- JP-A- 2006 132 111
- US-A- 4 936 063

## Beschreibung

### TECHNISCHES GEBIET

Die vorliegende Erfindung betrifft eine Photovoltaik-Moduleinrichtung mit einer Tragstruktur für Photovoltaikeinheiten.

### STAND DER TECHNIK

Es sind Photovoltaik-Moduleinrichtungen in unterschiedlichster Konstruktionsweise bekannt. Bei einer Ausführungsform werden die einzelnen Photovoltaik-Module auf ein Dach montiert und untereinander elektrisch miteinander verbunden. Dies bedeutet einen relativ hohen Montageaufwand und setzt zudem eine dichte Dachfläche voraus.

Aus der DE 10 2005 029 465 A1 ist eine Vorrichtung und ein Verfahren zur Wärmeenergieversorgung eines Gebäudes offenbart, das eine aus Solarmodulen bestehende Solaranlage aufweist, die beabstandet zu einer Unterkonstruktion des Gebäudes, zum Beispiel Dach- oder Fassadenkonstruktion, angeordnet ist, die sich dadurch auszeichnet, dass das zwischen der Unterseite der Solaranlage und der Oberseite der Unterkonstruktion vorhandene Luftraumvolumen als geschlossenes Raumvolumen mit zumindest einem Lufteingang und zumindest einem Luftausgang ausgebildet ist, wobei dieses Luftvolumen einer Warmluftverwertungseinrichtung zugeführt wird, die die in dem Raumluftvolumen vorhandene Wärmeenergie umsetzt und für das Gebäude nutzbar macht.

In der WO 01/75377 A1, WO 94/16170 A1 und JP 2000 027395 A sind Photovoltaik-Moduleinrichtungen mit einer Tragstruktur für Photovoltaikeinheiten beschrieben, die nebeneinander und hintereinander angeordnet sind. Die Tragstruktur weist hierbei eine modulare Rahmentragstruktur auf, wobei die Rahmenstruktureinheiten nebeneinander und hintereinander angeordnet sind und zusammen mit den Photovoltaikeinheiten eine geschlossene Fläche bilden. Zu Abdichtungszwecken sind zwischen den Rahmenstruktureinheiten Dichtungseinheiten vorhanden.

### DARSTELLUNG DER ERFINDUNG

Ausgehend von dem genannten Stand der Technik liegt der vorliegenden Erfindung die Aufgabe beziehungsweise das technische Problem zugrunde, eine Photovoltaik-Moduleinrichtung anzugeben, die in der Lage ist, als gesamte, flüssigkeitsdichte Dach- oder Fassadenfläche ausgebildet zu werden, die einfach montiert werden kann, die eine dauerhaft zuverlässige Funktion gewährleistet und hinsichtlich der jeweils am Bauwerk zu beachtenden Geometrie eine hohe Variabilität gewährleistet, wobei insbesondere das Ziel darin beseht, in konstruktiver einfacher und zuverlässiger Art und Weise die gesamte Dach- oder Fassadenfläche als Photovoltaik-Anlage auszubilden, ohne dass aufwendige zusätzliche Dichtarbeiten an der Dach- oder Fassadenkonstruktion erforderlich sind. Darüber hinaus soll die erfindungsgemäße Photovoltaik-Moduleinrichtung wirtschaftlich herstellbar sein, damit dem jeweiligen Bauherrn eine effektive und kostengünstige Lösung zur elektrischen Energieerzeugung zur Verfügung gestellt werden kann.

Die erfindungsgemäße Photovoltaik-Moduleinrichtung ist durch die Merkmale des unabhängigen Anspruchs 1 gegeben.

Vorteilhafte Ausgestaltungen und Weiterbildungen sind Gegenstand der von dem unabhängigen Anspruch 1 direkt oder indirekt abhängigen Ansprüche.

Die erfindungsgemäße Photovoltaik-Moduleinrichtung zeichnet sich sinngemäß dadurch aus, dass die Tragstruktur eine modulare Rahmentragstruktureinheit aufweist, wobei die Rahmentragstruktureinheit zumindest zwei beabstandete Seitenwangenträger aufweist, an denen eine Photovoltaikeinheit flüssigkeitsdicht eingearbeitet ist, einen ersten Querrandträger und einen beabstandet zum ersten Querrandträger angeordneten zweiten Querrandträger aufweist und die Photovoltaikeinheit mit einem über den ersten Querrandträger hinaus ragenden Überstand vorhanden ist, derart, dass sich die Photovoltaikeinheiten benachbart angeordneter Rahmentragstruktureinheiten überlappenn konnen.

Dadurch, dass die Moduleinrichtung in einfacher Art und Weise als Rahmentragstruktureinheit ausgebildet ist, können die jeweiligen einzelnen Rahmentragstruktureinheiten problemlos bei der Montage aneinander gefügt werden und insgesamt eine "wasserdichte" Fläche, sei es eine Dach- oder Fassadenfläche, erzeugen. Dadurch, dass zwischen den Photovoltaikeinheiten benachbarter Rahmentragstruktureinheiten einen Überstand besteht, ist eine Eindringen von Flüssigkeiten, insbesondere Regenwasser aufgrund der vertikalen oder geneigten Anordnung der Moduleinrichtungen, von vornherein nicht möglich.

Durch die einfache Struktur der erfindungsgemäßen Photovoltaik-Moduleinrichtung lässt sich diese wirtschaftlich herstellen, gewährleistet eine einfache Montage und stellt somit dem jeweiligen Bauherrn eine lukrative Möglichkeit dar, die Energieversorgung für ein Gebäude zu sichern. Zudem kann er die durch die erfindungsgemäße Photovoltaik-Moduleinrichtung erzeugte Energie im Falle eines Überschusses in ein Netz einspeisen, was ihm zusätzlich finanzielle Vorteile bringt, da die Energieversorger diese zusätzliche eingespeiste elektrische Energie vergüten müssen.

Weiterhin können alte Eternit (eingetragene Marke) - Dacheindeckungen durch die erfindungsgemäße Photovoltaik-Moduleinrichtung ersetzt werden, insbesondere ohne dass zusätzliche Dacheindeckungsmaßnahmen nötig sind. Durch die erfindungsgemäße Photovoltaik-Moduleinrichtung ist es möglich, geschlossene Dach- oder Fassadenflächen zu erzeugen, ohne dass zusätzliche Maßnahmen für die Dach- oder Fassadeneindeckung erforderlich sind.

Eine besonders vorteilhafte Ausgestaltung der erfindungsgemäßen Photovoltaik-Moduleinrichtung zeichnet sich dadurch aus, dass die modulare Rahmentragstruktureinheit als orthogonale Viereckeinheit, insbesondere rechteckige oder quadratische Einheit, ausgebildet ist. Durch die Wahl dieser einfachen Umfangskontur ist eine einfache Handhabung bei der Montage und auch bei der Herstellung gewährleistet. Weitere polygonale Umfangsstrukturen (zum Beispiel Dreieckkonturen) sind problemlos möglich.

Eine konstruktiv besonders einfache und daher auch bevorzugte Ausgestaltung zeichnet sich dadurch aus, dass die Seitenwangenträger im Bereich oberhalb des ersten Querrandträgers eine Vorsprungeinheit und im Bereich oberhalb des zweiten Querrandträgers eine Rücksprungeinheit aufweisen, derart, dass sich bei angeschlossenen benachbarten Rahmentragstruktureinheiten sich dieselbe Querschnittshöhe des Seitenwangenträgers wie im übrigen Bereich derselben ergibt, das heißt die Vorsprungeinheit im Wesentlichen diesselbe Umfangskontur aufweist wie die Rücksprungeinheit.

Eine bevorzugte Weiterbildung der erfindungsgemäßen Photovoltaik-Moduleinrichtung zeichnet sich dadurch aus, dass im Bereich des ersten und/oder zweiten Querrandträgers eine Dichteinheit angeordnet ist, die benachbart angeschlossene Rahmentragstruktureinheiten und Photovoltaikeinheiten flüssigkeitsdicht gegeneinander abdichtet.

Eine hinsichtlich der Flüssigkeitsabdichtung besonders bevorzugte Ausgestaltung zeichnet sich dadurch aus, dass die Photovoltaikeinheit gegenüber der Ebene der Rahmentragstruktureinheit geneigt vorhanden ist, wobei eine in diesem Sinne konstruktiv besonders einfache Weiterbildung sich dadurch auszeichnet, dass die Endrandbereiche der Photovoltaikeinheit oberhalb des ersten Querrandträgers beziehungsweise des zweiten Querrandträgers angeordnet ist, was auch die Stabilität der Moduleinrichtung erhöht.

Eine besonders vorteilhafte Ausgestaltung zeichnet sich dadurch aus, dass unterhalb der Photovoltaikeinheit Anschlussmöglichkeiten bestehen, um eine Wärmeisolierung anzubringen. Dies kann beispielsweise dadurch umgesetzt werden, dass die Seitenwangenträger innenseitig eine erste Nut aufweisen, in die beispielsweise eine Glasscheibe eingesetzt werden kann. Dadurch erhöht sich der Isolierwert der erfindungsgemäßen Photovoltaik-Moduleinrichtung deutlich.

Eine konstruktiv besonders vorteilhafte Ausgestaltung, die eine kompakte Verkabelung der einzelnen Photovoltaik-Moduleinrichtungen untereinander gewährleistet, zeichnet sich dadurch aus, dass die Seitenwangenträger innen- und/oder außenseitig Nute aufweisen, in denen problemlos elektrische Kabel verlegt werden können, die zur elektrischen Kommunikation benachbarter Photovoltaik-Moduleinrichtungen dienen und im Ergebnis einer zentralen Steuereinheit zugeführt werden, die die jeweils aktuelle Energiesituation analysiert, auswertet und nutzt.

Eine konstruktiv besonders einfache, eine wirtschaftliche Herstellung und eine dauerhaft zuverlässige Funktion gewährleistende vorteilhafte Ausgestaltung zeichnet sich dadurch aus, dass die Photovoltaikeinheit innerhalb einer Nut der Seitenwangenträger flüssigkeitsdicht angeordnet ist.

Als Material für die Rahmentragstruktureinheit wird bevorzugt Kunststoff, Aluminium oder Aluminiumschaum, insbesondere mit Faserverstärkung, eingesetzt.

Es ist auch in vorteilhafter Art und Weise möglich, für die Rahmenstruktureinheit Holz oder Holzwerkstoff, insbesondere beschichteten Holwerkstoff einzusetzen, wobei in vorteilhafter Art und Weise hinsichtlich einer wirtschaftlichen Herstellung die Beschichtung lediglich oberseitig angebracht ist.

Um die Stabilität der Rahmenkonstruktion zu erhöhen, ist in einer vorteilhaften Weiterbildung im Bereich zwischen dem ersten Querrandträger und dem zweiten Querrandträger von Seitenwangenträger zur Seitenwangenträger verlaufend eine Querverstärkungseinheit eingezogen.

Um einen einfachen elektrischen Anschluss benachbarter Photovoltaik-Moduleinrichtungen zu gewährleisten, zeichnet sich eine vorteilhafte Ausgestaltung dadurch aus, dass eine Buchsen-Steck-Verbindung vorhanden ist, die automatisch beim Aneinanderfügen benachbarter Rahmentragstruktureinheiten eine elektrisch leitende Verbindung herstellt.

Bevorzugt ist an der Rahmentragstruktureinheit eine elektrische Steuereinheit, insbesondere Platine, vorhanden, mittels derer die elektrische beziehungsweise elektronische Kommunikation benachbarter Photovoltaikeinheiten einstellbar beziehungsweise steuerbar ist.

Die elektrische Steuereinrichtung ist hierbei unter anderem in der Lage, wahlweise den Zustand paralleler oder serieller Schaltung benachbarter Photovoltaikeinheiten vorzunehmen.

Um zu einer während der Montage einfach handhabbaren Einheit zu gelangen, zeichnet sich eine bevorzugte Weiterbildung dadurch aus, dass die Länge der Photovoltaik-Moduleinrichtungen im Bereich zwischen 1 m bis 3 m (Meter), insbesondere im Bereich zwischen 1,6 m bis 2,0 m (Meter), liegt.

Des Weiteren besitzt jede Rahmentragstruktureinheit elektrische Anschlüsse, mittels derer eine elektrische beziehungsweise elektronische Kommunikation mit einer zentralen Steuer- und Auswerteinheit möglich ist.

Weitere Ausführungsformen und Vorteile der Erfindung ergeben sich durch die in den Ansprüchen ferner aufgeführten Merkmale sowie durch das nachstehend angegebene Ausführungsbeispiel. Die Merkmale der Ansprüche können in beliebiger Weise miteinander kombiniert werden, insoweit sie sich nicht offensichtlich gegenseitig ausschließen.

### KURZE BESCHREIBUNG DER ZEICHNUNG

Die Erfindung sowie vorteilhafte Ausführungsformen und Weiterbildungen derselben werden im Folgenden anhand der in der Zeichnung dargestellten Beispiele näher beschrieben und erläutert. Die der Beschreibung und der Zeichnung zu entnehmenden Merkmale können einzeln für sich oder zu mehreren in beliebiger Kombination erfindungsgemäß angewandt werden. Es zeigen:
- Fig. 1: schematische Draufsicht auf den Ausschnitt einer Dachfläche mit zwei benachbart angeordneten Photovoltaik-Moduleinrichtungen mit jeweils einer rechteckförmigen Rahmentragstruktureinheit,
- Fig. 2: schematische Unteransicht auf die Dachfläche gemäß Fig. 1,
- Fig. 3: schematischer Längsschnitt durch benachbart angeordnete Photovoltaik-Moduleinrichtungen,
- Fig. 4: schematischer Querschnitt durch eine Photovoltaik-Moduleinrichtung gemäß Fig. 3,
- Fig. 5: schematischer Detailquerschnitt durch die Seitenwangen einer erfindungsgemäßen Photovoltaik-Moduleinrichtung mit angeschlossener Profileinheit, die sowohl die Abdichtung benachbarter Moduleinrichtungen gewährleistet, einen Anschluss an die Unterkonstruktion ermöglicht und darüber hinaus Anschlussmöglichkeiten für weitere Bauteile zur Verfügung stellt, und
- Fig. 6: stark schematisierte Darstellung der Zusammenfassung mehrerer übereinander und nebeneinander angeordneter Photovoltaik-Moduleinrichtungen, die eine geschlossene Dach- oder Fassadenfläche bilden und elektrisch beziehungsweise elektronisch kommunizierend miteinander ausgebildet sind.

### WEGE ZUM AUSFÜHREN DER ERFINDUNG

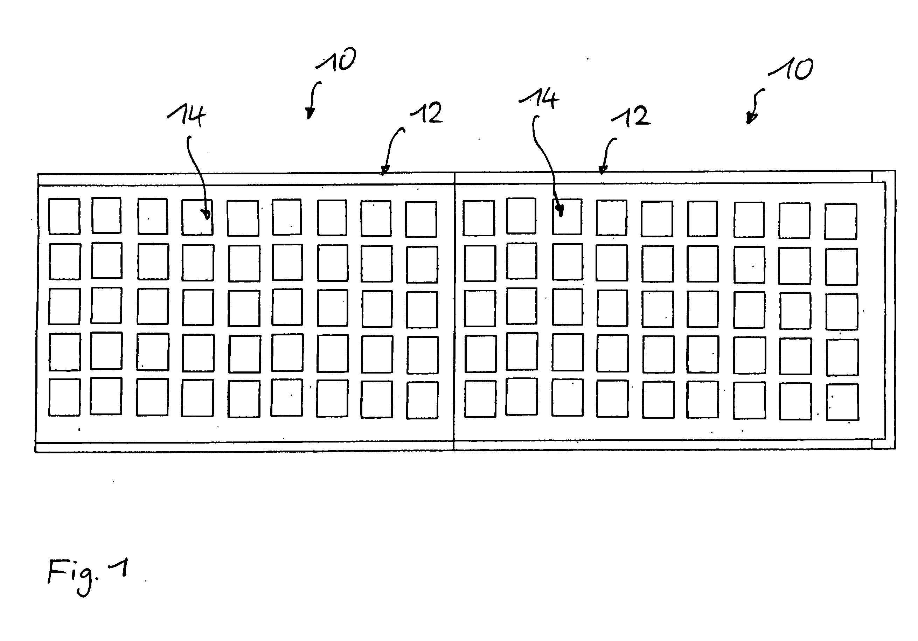

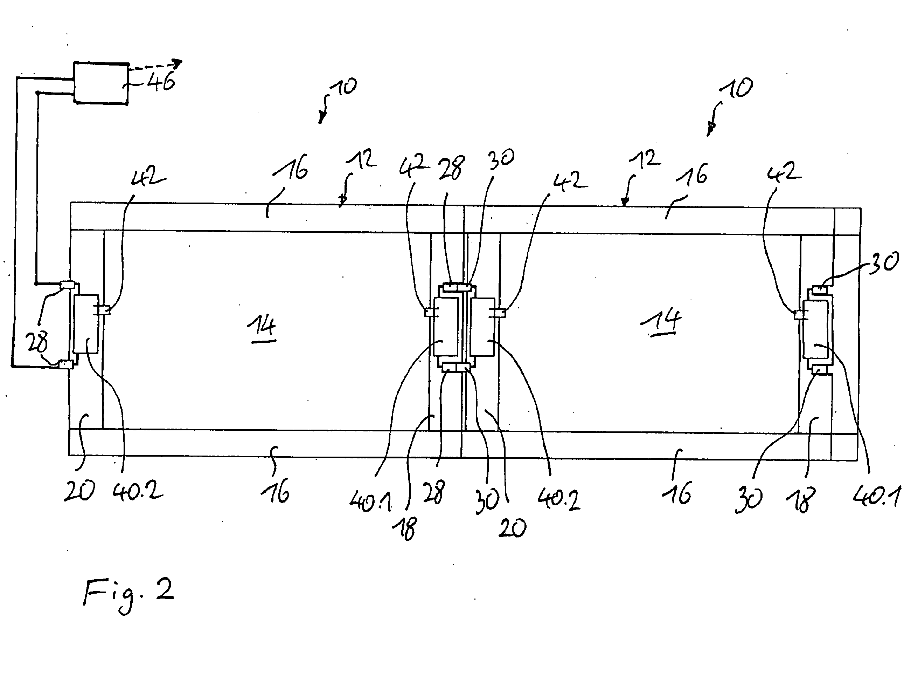

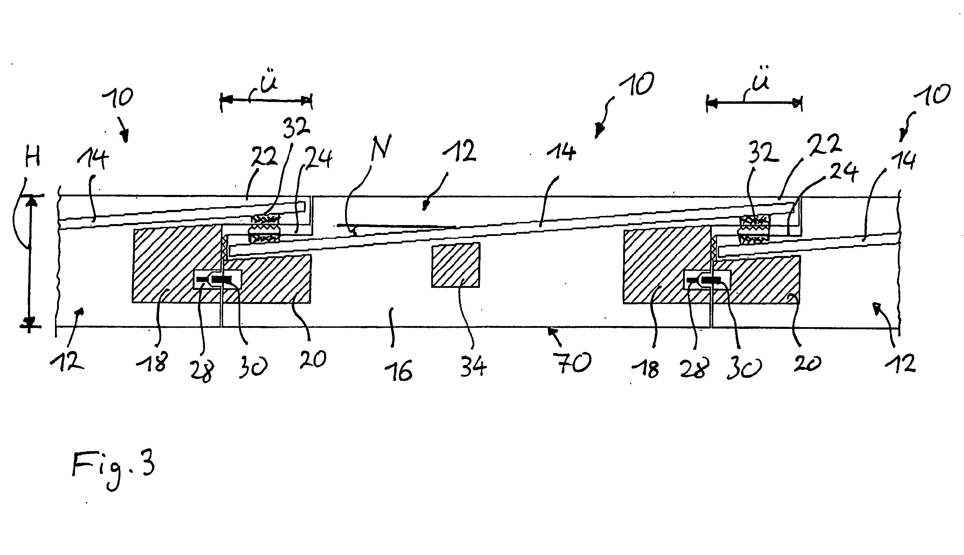

In den Fig. 1 bis 4 ist ein Ausführungsbeispiel einer Photovoltaik-Moduleinrichtung 10 dargestellt, wobei in Fig.1 und 2 zwei hintereinander benachbart angeordnete Photovoltaik-Moduleinrichtungen 10 und in Fig. 3 im Schnitt drei benachbart hintereinander angeordnete Photovoltaik-Moduleinrichtungen 10 dargestellt sind.

Die Photovoltaik-Moduleinrichtung 10 weist eine viereckförmige Rahmentragstruktureinheit 12 auf, die zwei parallel beabstandete Seitenwangenträger 16 besitzt, die jeweils in ihrem in Fig. 3 rechten Endbereich über einen ersten Querrandträger 18 und in ihrem in Fig. 3 linken Endbereich über einen zweiten Querrandträger 20 miteinander verbunden sind. In der Mitte zwischen dem ersten Querrandträger 18 und dem zweiten Querrandträger 20 ist zur Stabilisierung eine parallel verlaufende, an den Seitenwangenträgern 16 angeschlossene Querverstärkungseinheit 34 vorhanden.

Die Seitenwangenträger 16 weisen eine Höhe H auf. Im in Fig. 3 rechten Endbereich weist jeder Seitenwangenträger 16 eine rechteckförmige Vorsprungeinheit 22 auf und in dem in Fig. 3 linken Endbereich ist eine rechteckförmige Rücksprungeinheit 24 in die Seitenwangenträger 16 eingeformt. Die Geometrie der Vorsprungeinheit 22 und der Rücksprungeinheit 24 ist dabei so bemessen, dass bei benachbart hintereinander angeordneten Photovoltaik-Moduleinrichtungen 10 die Vorsprungeinheit 22 die Rücksprungeinheit 24 überlappt und sich dieselbe Querschnittshöhe H ergibt, wie im übrigen Bereich der Seitenwangenträger 16.

Der zweite Querrandträger 20 weist eine geringere Querschnittshöhe als der erste Querrandträger 18 auf. Oberhalb des ersten Querrandträgers 18 und dem zweiten Querrandträger 20 verläuft durchgehend eine Photovoltaikeinheit 14, die zur Längsrichtung des Seitenwangenträgers 16 eine Neigung N aufweist, dahingehend, dass die Photovoltaikeinheit 14 vom zweiten Querrandträger 20 zum ersten Querrandträger 18 ansteigend verläuft. Die Photovoltaikeinheit 14 verläuft hierbei bis in den Bereich der Vorsprungeinheit 22 hinein.

Die Photovoltaikeinheit 14 ist in ihren gegenüberliegenden Seitenrändern jeweils in einer innenseitig an den Seitenwangenträgern 16 vorhandenen Nut 26 flüssigkeitsdicht gelagert.

Die Rahmentragstruktureinheit 12 ist mit ihren Seitenwangenträgern 16 auf einer nicht näher dargestellten Unterkonstruktion 70 des Daches oder der Fassade gelagert.

Die Photovoltaikeinheit 14 verläuft auch bis in den Bereich unterhalb der Rücksprungeinheit 24, so dass bei benachbart angeordneten Photovoltaik-Moduleinrichtungen 10 die benachbarten Photovoltaikeinheiten 14 einen Überstand Ü aufweisen. In diesem Überstandsbereich Ü ist zwischen den benachbarten Rahmentragstruktureinheiten 12 beziehungsweise den benachbart überlappenden Photovoltaikeinheiten 14 eine in Querrichtung verlaufende erste Dichteinheit 32 angeordnet. Des Weiteren ist an der freien Stirnseite der Seitenwangenträger 16 unterhalb der Rücksprungeinheit 24 eine zweite Dichteinheit 33 vorhanden, die den Spalt zwischen benachbarten Seitenwangenträgern 16 flüssigkeitsdicht abdichtet.

Die Rahmentragstruktureinheit 12 kann beispielsweise aus einem, insbesondere faserverstärkten, Aluminiumschaummaterial gebildet sein. Es kann jedoch auch Kunststoff oder Holz zum Einsatz kommen. Des Weiteren können für die Rahmentragstruktureinheit 12 Aluminiumstrangpressprofile verwendet werden.

Unterhalb des ersten Querrandträgers 18 und des zweiten Querrandträgers 20 ist jeweils eine elektronische Steuereinheit 40.1, 40.2 vorhanden, die elektronische Variationsmöglichkeiten offen lässt und beispielsweise eine Umschaltung parallel/seriell der einzelnen Photovoltaikeinheiten 14 mittels beispielsweise Bustechnologie zur Kommunikation mit Wechselrichtern ermöglicht.

Mit der unterhalb dem ersten Querrandträger 18 vorhandenen elektrischen Steuereinheit 40.1 stehen jeweils zwei erste elektrische Anschlusseinheiten 28 in Kommunikationsverbindung, die als Buchse ausgebildet sind. Gegenüberliegend steht die unterhalb des zweiten Querrandträgers 20 angeordnete elektrische Steuereinheit 40.2 mit zwei zweiten elektrischen Anschlusseinheiten 30 in Kommunikationsverbindung, die als Stecker ausgebildet sind. Bei der Montage benachbarter Photovoltaik-Moduleinrichtungen 10 werden die ersten Anschlusseinheiten 28 automatisch mit den beiden Anschlusseinheiten 30 kontaktiert, so dass eine elektrisch leitende Verbindung zwischen den einzelnen benachbarten Photovoltaikeinheiten 14 gegeben ist.

Die elektrische Steuereinheit 40.1 beziehungsweise 40.2 ist dabei so ausgebildet, dass benachbarte Photovoltaikeinheiten 14 entweder parallel oder in Serie geschaltet werden können.

Die Steuereinheiten 40.1, 40.2 sind bevorzugt in einer Ausnehmung der Querrandträger 18 beziehungsweise 20 angeordnet und mit einem Deckel verschlossen oder in einem separaten Gehäuse an die Querrandträger 18, 20 angeordnet.

Die elektronischen Steuereinheiten 40.1, 40.2 besitzen weiterhin einen Anschluss 42, an das ein Kabel anschließbar ist, das zur Kommunikation mit einer zentralen Steuereinheit verbunden ist.

Diese Steuereinheit kann beispielsweise ein Wechselrichter sein, der über Bustechnologie mit weiteren Wechselrichtern verbunden ist, und einer zentralen Steuereinheit zugeführt wird, damit der jeweilige aktuelle Zustand der Photovoltaikeinheiten 14 abgefragt werden kann.

Zusätzlich können an den Querrandträgern 18, 20 Anschlüsse für Kabel vorhanden sein, die einerseits an eine zentrale Steuer- und Auswerteinheit angeschlossen sind und andererseits den Anschluss zu den Steuereinheiten 40.1, 40.2 ermöglichen. Derartige Anschlüsse sind in den Figuren nicht näher dargestellt.

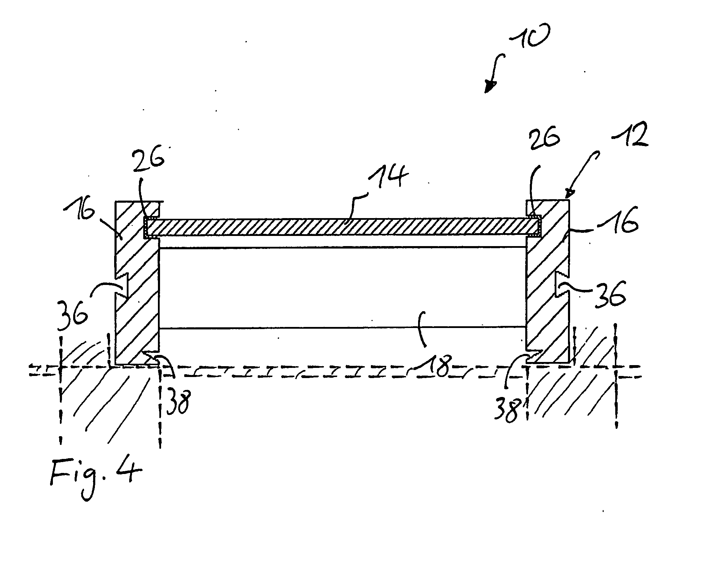

Wie in Fig. 4 dargestellt weisen die Seitenwangenträger 16 eine durchgehende erste Nut 36, die außenseitig angebracht ist und dazu dient, elektrische Kabel zum Anschluss an die Steuereinheiten 40.1, 40.2 aufzunehmen und vom Wechselrichter her zuzuführen. Es können mehrere erste Nute 36 vorhanden sein, die auch innenseitig in den Seitenwangenträger 16 eingeformt sein können.

Schließlich ist noch im unteren Randbereich der Seitenwangenträger 16 innenseitig eine zweite Nut 38 vorhanden, die dazu geeignet ist, beispielsweise den Seitenrandbereich einer Glasplatte aufzunehmen, so dass die Isoliereigenschaften der Photovoltaik-Moduleinrichtung 10 verbessert werden.

In den Figuren sind die benachbarten Photovoltaik-Moduleinrichtungen 10 so dargestellt, wie sie in Fallrichtung von links nach rechts des Daches beziehungsweise einer Fassade verlegt werden. In Querrichtung zu dieser Fallrichtung werden die Photovoltaik-Moduleinrichtungen 10 jeweils mit parallel angeordneten Seitenwangenträgern 16 verlegt, wobei zwischen den Seitenwangenträgern 16 seitlich benachbarter Photovoltaik-Moduleinrichtungen 10 ein Dichtprofil eingesetzt wird, was in der Figur 4 nicht näher dargestellt ist. Dadurch lassen sich beliebige Dach- und/oder Fassadenflächen gestalten, wobei die gesamten Photovoltaik-Moduleinrichtungen 10 insgesamt eine flüssigkeitsdichte Fläche bilden.

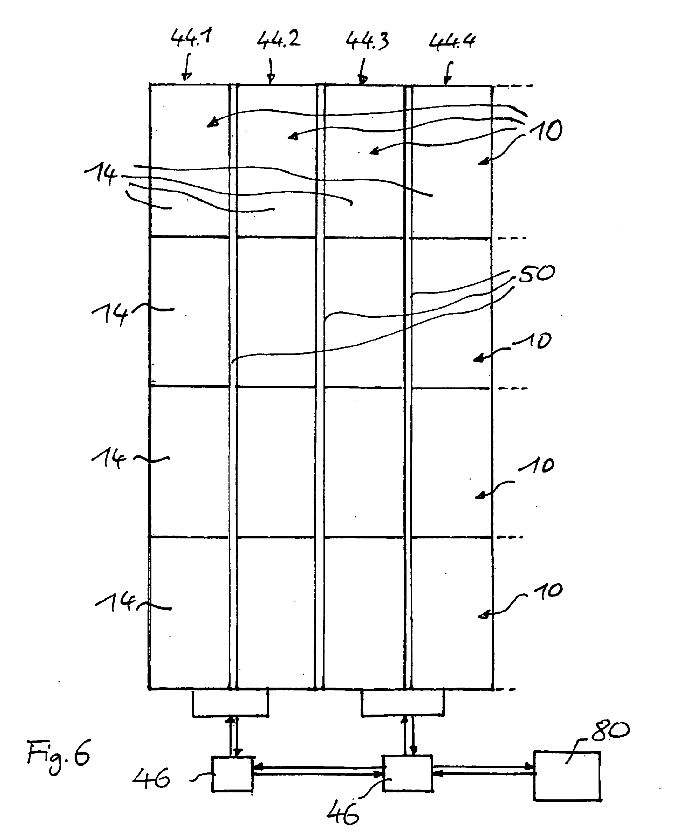

In Fig. 6 ist stark schematisiert dargestellt, wie einzelne Photovoltaik-Moduleinrichtungen 10, die zunächst übereinander angeordnet sind, einzelne Strings 44.1, ...., 44.4 bilden, wobei die jeweiligen nebeneinander angeordnete Strings 44.1, ...., 44.4 über Profileinheiten 50 einerseits flüssigkeitsdicht miteinander verbunden sind und andererseits durch die jeweilige Profileinheit 50 an die entsprechende Unterkonstruktion angeschlossen sind, so dass sie eine ebene, flüssigkeitsdichte Fläche bilden. Die jeweiligen Strings 44.1, ...., 44.4 sind elektrisch kommunizierend jeweils mit einem Wechselrichter 46 verbunden, der je nach Ausgestaltung seine Information weitergibt an einen weiteren Wechselrichter 46, der dann den Informationszustand der einzelnen Strings 44.1 beziehungsweise Photovoltaikeinheiten 14 an eine zentrale Steuereinheit 80 abgibt, über die der jeweilige Schaltungszustand der Dach- beziehungsweise Fassadenfläche steuerbar ist. Umgekehrt kann die Steuereinheit 80 dann entsprechende Photovoltiakeinheiten 14 ansteuern, um in Abstimmung mit der Energieversorgung des Gebäudes Vorkehrungen zu treffen.

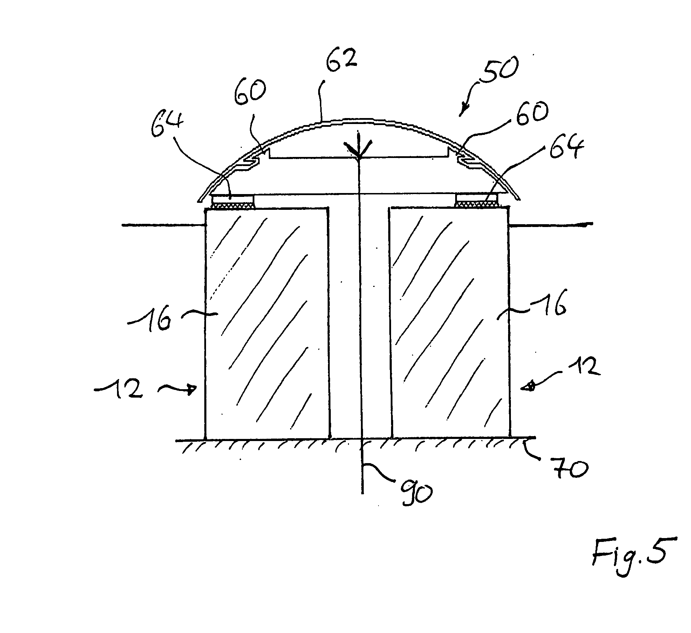

In Fig. 5 ist stark schematisiert der Bereich im Querschnitt dargestellt, in dem zwei Photovoltaik-Moduleinrichtungen 10 nebeneinander angeordnet sind, wobei die von oben her im Rahmen einer eine flüssigkeitsdichten Gesamtfläche erzeugende Gesamtstruktur eine Profileinheit 50 angeordnet ist, die jeweils über Dichteinheiten 64 auf benachbarten Seitenwangenträgern 60 einer Photovoltaik-Moduleinrichtung 10 flüssigkeitsdicht angeordnet ist und über eine schematisch dargestellte Schraubverbindung 90 mit der Unterkonstruktion 70 verbunden ist.

Die Profileinheit 50 ist hierbei so ausgestaltet, dass sie einerseits benachbart angeordnete Rahmenstruktureinheiten 12 flüssigkeitsdicht verbindet, eine sichere Anbindung an die Unterkonstruktion 70 gewährleistet und darüber hinaus durch ihre Profilausgestaltung im oberseitigen Bereich den Anschluss unterschiedlichster Bauteile ermöglicht. Hierzu weist die Profileinheit 50 Anschlusseinheiten 60 auf, die beispielsweise den Anschluss einer zusätzlichen lösbaren Abdeckkappenleiste 62 gewährleistet.

An die Anschlusseinheiten 60 der Profileinheit 50 sind darüber hinaus Anschlussmöglichkeiten gegeben, die insbesondere bei Wartungs-, Reparatur- und Montagearbeiten besonders vorteilhaft sind. So können die Anschlusseinheiten 60 der Profileinheit 50 zumindest temporär dazu genutzt werden, um eventuelle Leitersprossen bei möglicherweise erforderlichen Reparaturen, Gerüste, Reinigungsmaschinen, Sicherungsgurte während der Montage oder sonstige Anschlussmöglichkeiten zu bieten, um eine dauerhafte Funktionalität der gesamten Dach- oder Fassadenfläche während und nach deren Montage zu gewährleisten.

Die erfindungsgemäße Photovoltaik-Moduleinrichtung 10 ermöglicht somit eine Erstellung einer Dach- oder Fassadenfläche ohne dass die übliche Dichtstruktur mittels Ziegeln oder dergleichen Bauteile gewährleistet werden muss, und gewährleistet darüber hinaus eine optimale, kostensparende Montage, wobei gleichzeitig eine dauerhaft zuverlässige Funktion gewährleistet ist.

## Patentansprüche

1. Photovoltaik-Moduleinrichtung (10) mit einer Tragstruktur für Photovoltaikeinheiten (14), wobei
- die Tragstruktur eine modulare Rahmentragstruktureinheit (12) aufweist, wobei
- die Rahmentragstruktureinheit (12)
-- zumindest zwei beabstandete Seitenwangenträger (16) aufweist, an denen eine Photovoltaikeinheit (14) flüssigkeitsdicht eingearbeitet ist,
-- einen ersten Querrandträger (18) und einen beabstandet zum ersten Querrandträger (18) angeordneten zweiten Querrandträger (20) aufweist, **dadurch gekennzeichnet, dass**
-- die Photovoltaikeinheit (14) mit einem über den ersten Querrandträger (18) hinaus ragenden Überstand (Ü) vorhanden ist, derart, dass sich die Photovoltaikeinheiten (14) benachbart angeordneter Rahmentragstruktureinheiten (12) überlappen können.

2. Photovoltaik-Moduleinrichtung nach Anspruch 1,
- **dadurch gekennzeichnet, dass**
- die Rahmentragstruktureinheit (12) als orthogonale Viereckstruktureinheit, insbesondere als Rechteck- oder Quadrateinheit, oder als Dreieckstruktur, ausgebildet ist.

3. Photovoltaik-Moduleinrichtung nach Anspruch 1 oder 2,
- **dadurch gekennzeichnet, dass**
- die Seitenwangenträger (16) im Bereich oberhalb des ersten Querrandträgers (18) eine Vorsprungeinheit (22) und im Bereich oberhalb des zweiten Querrandträgers (20) eine Rücksprungeinheit (24) aufweisen, derart, dass sich bei angeschlossenen benachbarten Rahmentragstruktureinheiten (12) sich dieselbe Querschnittshöhe (H) des Seitenwangenträgers (16) wie im übrigen Bereich derselben ergibt, das heißt die Vorsprungeinheit (22) im Wesentlichen dieselbe Umfangskontur aufweist wie die Rücksprungeinheit (24).

4. Photovoltaik-Moduleinrichtung nach einem oder mehreren der vorstehenden Ansprüche,
- **dadurch gekennzeichnet, dass**
- im Bereich des ersten und/oder zweiten Querrandträgers (18, 20) eine Dichteintheit (32) angeordnet ist, die benachbart angeschlossene Rahmentragstruktureinheiten (12) und Photovoltaikeinheiten (14) flüssigkeitsdicht gegeneinander abdichtet.

5. Photovoltaik-Moduleinrichtung nach einem oder mehreren der vorstehenden Ansprüche,
- **dadurch gekennzeichnet, dass**
- die Photovoltaikeinheit (14) gegenüber der Ebene der Rahmentragstruktureinheit (12) geneigt vorhanden ist.

6. Photovoltaik-Moduleinrichtung nach Anspruch 5,
- **dadurch gekennzeichnet, dass**
- die Endrandbereiche der Photovoltaikeinheit (14) oberhalb des ersten Querrandträgers (18) und des zweiten Querrandträgers (20) angeordnet sind.

7. Photovoltaik-Moduleinrichtung nach einem oder mehreren der vorstehenden Ansprüche,
- **dadurch gekennzeichnet, dass**
- die Photovoltaikeinheit (14) innerhalb einer Nut (26) der Seitenwangenträger (16) flüssigkeitsdicht angeordnet ist.

8. Photovoltaik-Moduleinrichtung nach einem oder mehreren der vorstehenden Ansprüche,
- **dadurch gekennzeichnet, dass**
- unterhalb der Photovoltaikeinheit (14) isolierendes Material angeordnet ist.

9. Photovoltaik-Moduleinrichtung nach einem oder mehreren der vorstehenden Ansprüche,
- **dadurch gekennzeichnet, dass**
- die Seitenwangenträger (16) innenseitig eine Anschlusseinrichtung, insbesondere erste Nut (38), zum Anschluss von isolierendem Material, insbesondere einer Glasscheibe oder zum Anschluss einer Heizeinheit als Zusatzfunktion, aufweisen.

10. Photovoltaik-Moduleinrichtung nach einem oder mehreren der vorstehenden Ansprüche,
- **dadurch gekennzeichnet dass**
- außen- und/oder innenseitig der Seitenwangenträger (16) eine Anschlusseinrichtung, insbesondere zweite Nut (36), für Kabeleinheiten vorhanden ist.

11. Photovoltaik-Moduleinrichtung nach einem oder mehreren der vorstehenden Ansprüche,
- **dadurch gekennzeichnet, dass**
- die Rahmentragstruktureinheit (12) als Holz oder Holzwerkstoffbauteil oder als Kunststoffbauteil, insbesondere gespritztes oder tiefgezogenes Kunststoffbauteil, insbesondere mit Faserverstärkung oder als Aluminiumstrangpressprofil oder als Aluminiumschaumkonstruktion, insbesondere als faserverstärkte Aluminiumschamnkonstruktion, ausgebildet ist.

12. Photovoltaik-Moduleinrichtung nach einem oder mehreren der vorstehenden Ansprüche,
- **dadurch gekennzeichnet, dass**
- zwischen dem ersten Querrandträger (18) und dem zweiten Querrandträger (20) zusätzlich eine Querverstärkungseinheit (34) vorhanden ist.

13. Photovoltaik-Moduleinrichtung nach einem oder mehreren der vorstehenden Ansprüche,
- **dadurch gekennzeichnet, dass**
- die Photovoltaikeinheiten (14) benachbarter Rahmentragstruktureinheiten (12) über eine Buchsen-Steck-Verbindung elektrisch miteinander verbunden sind.

14. Photovoltaik-Moduleinrichtung nach einem oder mehreren der vorstehenden Ansprüche,
- **dadurch gekennzeichnet, dass**
- die Rahmentragstruktureinheit (12) eine elektrische Steuereinheit (40) besitzt, mittels derer die elektrische beziehungsweise elektronische Kommunikation benachbarter Photovoltaikeinheiten (14) einstellbar beziehungsweise steuerbar ist.

15. Photovoltaik-Moduleinrichtung nach einem oder mehreren der vorstehenden Ansprüche,
- **dadurch gekennzeichnet, dass**
- jede modulare Rahmentragstruktureinheit (12) elektrische Anschlüsse besitzt, mittels derer eine elektrische beziehungsweise elektronische Kommunikation mit einer zentralen Steuer- und Auswerteinheit ermöglicht wird.

## Claims

1. Photovoltaic module device (10) having a supporting structure for photovoltaic units (14), with
- the supporting structure having a modular frame supporting structural unit (12), with
- the frame supporting structural unit (12)
-- having at least two side cheek supports (16) which are at a distance from one another and in which a photovoltaic unit (14) is incorporated in a liquid-tight manner,
-- a first transverse edge support (18) and a second transverse edge support (20) which is arranged at a distance from the first transverse edge support (18), **characterized in that**
-- the photovoltaic unit (14) has a projection (Ü), which projects beyond the first transverse edge support (18), in such a way that the photovoltaic units (14) can overlap adjacent frame supporting structural units (12).

2. Photovoltaic module device according to Claim 1,
- **characterized in that**
- the frame supporting structural unit (12) is in the form of an orthogonal quadrilateral structural unit, in particular in the form of a rectangular or square unit, or in the form of a triangular structure.

3. Photovoltaic module device according to Claim 1 or 2,
- **characterized in that**
- the side cheek supports (16) have a projection unit (22) in the region above the first transverse edge support (18), and a return unit (24) in the region above the second transverse edge support (20) in such a way that, when adjacent frame supporting structural units (12) are connected, the same cross-sectional height (H) for the side cheek support (16) is produced as in the other region of the said side cheek supports, that is to say the projection unit (22) has substantially the same peripheral contour as the return unit (24).

4. Photovoltaic module device according to one or more of the preceding claims,
- **characterized in that**
- a sealing unit (32) is arranged in the region of the first and/or second transverse edge support (18, 20), the said sealing unit sealing off adjacently connected frame supporting structural units (12) and photovoltaic units (14) from one another in a liquid-tight manner.

5. Photovoltaic module device according to one or more of the preceding claims,
- **characterized in that**
- the photovoltaic unit (14) is inclined in relation to the plane of the frame supporting structural unit (12).

6. Photovoltaic module device according to Claim 5,
- **characterized in that**
- the end edge regions of the photovoltaic unit (14) are arranged above the first transverse edge support (18) and the second transverse edge support (20).

7. Photovoltaic module device according to one or more of the preceding claims,
- **characterized in that**
- the photovoltaic unit (14) is arranged within a groove (26) in the side cheek supports (16) in a liquid-tight manner.

8. Photovoltaic module device according to one or more of the preceding claims,
- **characterized in that**
- insulating material is arranged beneath the photovoltaic unit (14).

9. Photovoltaic module device according to one or more of the preceding claims,
- **characterized in that**
- the side cheek supports (16) have, on the inside, a connection device, in particular a first groove (38), for connecting insulating material, in particular a glass pane, or for connecting a heating unit as an auxiliary function.

10. Photovoltaic module device according to one or more of the preceding claims,
- **characterized in that**
- a connection device, in particular a second groove (36), for cable units is present on the outsize and/or inside of the side cheek supports (16).

11. Photovoltaic module device according to one or more of the preceding claims,
- **characterized in that**
- the frame supporting structural unit (12) is formed from wood or wood material or as a plastic component, in particular an injection-moulded or thermoformed plastic component, in particular with fibre-reinforcement, or as an extruded aluminium profile or as an aluminium foam construction, in particular as a fibre-reinforced aluminium foam construction.

12. Photovoltaic module device according to one or more of the preceding claims,
- **characterized in that**
- a transverse reinforcing unit (34) is additionally present between the first transverse edge support (18) and the second transverse edge support (20).

13. Photovoltaic module device according to one or more of the preceding claims,
- **characterized in that**
- the photovoltaic units (14) of adjacent frame supporting structural units (12) are electrically connected to one another by means of a socket/plug connection.

14. Photovoltaic module device according to one or more of the preceding claims,
- **characterized in that**
- the frame supporting structural unit (12) has an electrical control unit (40) by means of which electrical or electronic communication between adjacent photovoltaic units (14) can be adjusted or controlled.

15. Photovoltaic module device according to one or more of the preceding claims,
- **characterized in that**
- each modular frame supporting structural unit (12) has electrical connections by means of which electrical or electronic communication with a central control and evaluation unit is made possible.

## Revendications

1. Dispositif modulaire photovoltaïque (10) avec une structure porteuse pour des unités photovoltaïques (14), dans lequel
- la structure porteuse présente une unité de structure porteuse de cadre modulaire (12),
- l'unité de structure porteuse de cadre (12) présentant
-- au moins deux poutres de support latérales espacées (16) sur lesquelles l'unité photovoltaïque (14) est adaptée de manière étanche aux liquides,
-- une première poutre de bord transversale (18) et une deuxième poutre de bord transversale (20) disposée à distance de la première poutre de bord transversale (18),
caractérisé en ce
-- que l'unité photovoltaïque (14) est présente avec une saillie (Ü) dépassant de la première poutre de bord transversale (18) de telle manière que les unités photovoltaïques (14) d'unités de structure porteuse de cadre (12) adjacentes puissent se chevaucher.

2. Dispositif modulaire photovoltaïque selon la revendication 1,
- **caractérisé en ce**
- **que** l'unité de structure porteuse de cadre (12) est réalisée sous la forme d'une unité de structure quadrangulaire orthogonale, en particulier sous la forme d'une unité rectangulaire ou carrée, ou sous la forme d'une structure triangulaire.

3. Dispositif modulaire photovoltaïque selon la revendication 1 ou 2,
- **caractérisé en ce**
- **que** les poutres de support latérales (16) présentent dans la zone située au-dessus de la première poutre de bord transversale (18) une unité en saillie (22) et dans la zone située au-dessus de la deuxième poutre de bord transversale (20) une unité en retrait (24), de telle manière que lorsque des unités de structure porteuse de cadre (12) adjacentes sont raccordées, on obtienne la même hauteur de section transversale (H) de la poutre de support latérale (16) que dans la zone restante de celle-ci, c'est-à-dire que l'unité en saillie (22) présente essentiellement le même contour périphérique que l'unité en retrait (24).

4. Dispositif modulaire photovoltaïque selon une ou plusieurs des revendications précédentes,
- **caractérisé en ce**
- **que** dans la zone de la première et/ou deuxième poutre de bord transversale (18, 20) est disposée une unité d'étanchéité (32) qui rend les unités de structure porteuse de cadre (12) et les unités photovoltaïques (14) adjacentes raccordées étanches aux liquides les unes par rapport aux autres.

5. Dispositif modulaire photovoltaïque selon une ou plusieurs des revendications précédentes,
- **caractérisé en ce**
- **que** l'unité photovoltaïque (14) est inclinée par rapport au plan de l'unité de structure porteuse de cadre (12).

6. Dispositif modulaire photovoltaïque selon la revendication 5,
- **caractérisé en ce**
- **que** les zones de bord terminales de l'unité photovoltaïque (14) sont disposées au-dessus de la première poutre de bord transversale (18) et de la deuxième poutre de bord transversale (20).

7. Dispositif modulaire photovoltaïque selon une ou plusieurs des revendications précédentes,
- **caractérisé en ce**
- **que** l'unité photovoltaïque (14) est disposée de manière étanche aux liquides à l'intérieur d'une rainure (26) des poutres de support transversales (16).

8. Dispositif modulaire photovoltaïque selon une ou plusieurs des revendications précédentes,
- **caractérisé en ce**
- **qu'**un matériau isolant est disposé sous l'unité photovoltaïque (14).

9. Dispositif modulaire photovoltaïque selon une ou plusieurs des revendications précédentes,
- **caractérisé en ce**
- **que** les poutres de support transversales (16) présentent du côté intérieur un dispositif de raccordement, en particulier une première rainure (38), pour le raccordement d'un matériau isolant, en particulier d'une vitre, ou pour le raccordement d'une unité chauffante en tant que fonction supplémentaire.

10. Dispositif modulaire photovoltaïque selon une ou plusieurs des revendications précédentes,
- **caractérisé en ce**
- **qu'**un dispositif de raccordement, en particulier une deuxième rainure (36), pour des unités de câble est présent du côté extérieur et/ou intérieur des poutres de support transversales (16).

11. Dispositif modulaire photovoltaïque selon une ou plusieurs des revendications précédentes,
- **caractérisé en ce**
- **que** l'unité de structure porteuse de cadre (12) est réalisée en bois, en matériau à base de bois ou sous la forme d'un élément en matière plastique, en particulier d'un élément en matière plastique injectée ou emboutie, en particulier renforcée par fibres, ou sous la forme d'un profilé en aluminium extrudé ou d'une construction en mousse d'aluminium, en particulier d'une construction en mousse d'aluminium renforcée par fibres.

12. Dispositif modulaire photovoltaïque selon une ou plusieurs des revendications précédentes,
- **caractérisé en ce**
- **qu'**une unité de renfort transversal (34) est présente en plus entre la première poutre de bord transversale (18) et la deuxième poutre de bord transversale (20).

13. Dispositif modulaire photovoltaïque selon une ou plusieurs des revendications précédentes,
- **caractérisé en ce**
- **que** les unités photovoltaïques (14) d'unités de structure porteuse de cadre (12) adjacentes sont reliées entre elles électriquement par une liaison à douille et à fichue,

14. Dispositif modulaire photovoltaïque selon une ou plusieurs des revendications précédentes,
- **caractérisé en ce**
- **que** l'unité de structure porteuse de cadre (12) possède une unité de commande électrique (40) au moyen de laquelle la communication électrique et/ou électronique d'unités photovoltaïques (14) adjacentes peut être réglée et/ou commandée.

15. Dispositif modulaire photovoltaïque selon une ou plusieurs des revendications précédentes,
- **caractérisé en ce**
- **que** chaque unité de structure porteuse de cadre modulaire (12) possède des connexions électriques au moyen desquelles une communication électrique et/ou électronique avec une unité centrale de commande et d'évaluation est possible.
